# EUROPEAN PATENT SPECIFICATION

(11) **EP 2 374 852 B1**
(45) Date of publication and mention of the grant of the patent: **05.04.2017**
(21) Application number: 11161123.2
(22) Date of filing: 05.04.2011
(51) Int. Cl.: C09G 1/02, H01L 21/321

(54) **A method of polishing an object having a conductor layer made of copper or a copper alloy**
Verfahren zum Polieren eines Gegenstands mit einer Leiterschicht aus Kupfer, oder einer Kupferlegierung
Procédé de polissage un objet ayant une couche conductrice en cuivre ou en un alliage de cuivre

(30) Priority: 08.04.2010 JP 2010089698
(43) Date of publication of application: 12.10.2011
(73) Proprietor: FUJIMI INCORPORATED, Kiyosu-shi Aichi 452-8502 (JP)
(72) Inventor: Hirano, Tatsuhiko, Kiyosu-shi Aichi 452-8502 (JP); Tamada, Shuichi, Kiyosu-shi Aichi 452-8502 (JP); Umeda, Takahiro, Kiyosu-shi Aichi 452-8502 (JP)
(74) Representative: Neuefeind, Regina

(56) References cited:
- WO-A1-2004/085311
- WO-A1-2009/070969
- US-A- 3 864 296
- US-A1- 2008 276 543
- US-A1- 2008 290 317
- "Ullmann's Enciclopedia of Industrial Chemistry, Silica", ULLMANN'S ENCYCLOPEDIA OF INDUSTRIAL CHEMISTRY, XX, XX, 1 April 2007 (2007-04-01), pages 1-89, XP002460901,

## Description

### BACKGROUND OF THE INVENTION

The present invention relates to a polishing composition to be used in polishing, for example, for forming the wiring of a semiconductor device and a polishing method using the polishing composition.

In forming the wiring of a semiconductor device, first, a barrier layer and a conductor layer are sequentially formed in this order on an insulator layer having trenches. Subsequently, at least a portion of the conductor layer positioned outside the trenches, an outer portion of the conductor layer, and a portion of the barrier layer positioned outside the trenches, an outer portion of the barrier layer, are removed by chemical mechanical polishing. The polishing for removing at least the outer portion of the conductor layer and the outer portion of the barrier layer is usually performed by two separate steps, namely, a first polishing step and a second polishing step. In the first polishing step, the outer portion of the conductor layer is partially removed to expose the upper surface of the barrier layer. In the following second polishing step, at least the remnant of the outer portion of the conductor layer and the outer portion of the barrier layer are removed to expose the insulator layer and obtain a flat surface.

In such a polishing for forming the wiring of a semiconductor device, in particular, in the second polishing step, it is common to use a polishing composition containing a polishing accelerator such as an acid; and an oxidant; and further, where necessary, a polishing abrasive grains. Additionally, it has been proposed to use a polishing composition further containing a water-soluble polymer for the purpose of achieving an improvement of the flatness of an object to be polished after having been polished. For example, Japanese Laid-Open Patent Publication No. 2008-41781 discloses the use of a polishing composition containing an anionic surfactant such as ammonium polyoxyethylene lauryl ether sulfate, a protective film forming agent such as benzotriazole, and a nonionic surfactant such as polyoxyethylene alkyl ether. Japanese Laid-Open Patent Publication No. 2002-110595 discloses the use of a polishing composition containing an epihalohydrin-modified amide. Japanese Laid-Open Patent Publication No. 2008-244316 discloses the use of a polishing composition containing a chemically-modified gelatin having an amino group modified with a carboxylic acid. WO 2004/085311 A1 discloses a dispersion containing pyrogenicall produced silicon powder and the use thereof. US2007/0290317 A1 relates to a pyrogenically prepared silicon powder and a dispersion comprising the same.

In the case where the wiring of a semiconductor device is formed with chemical mechanical polishing, particularly when the conductor layer is made of copper or a copper alloy, unintended inconvenient depressions may form beside the formed wiring lines. Such depressions beside the wiring lines is considered to be mainly caused by corrosion occurring during polishing on the surface of the conductor layer in the vicinity of the vertical boundary between the conductor layer and the insulator layer. It is difficult to prevent the formation of depressions beside the wiring lines even by using such conventional polishing compositions as described above.

### SUMMARY OF THE INVENTION

Accordingly, an objective of the present invention is to provide a method of polishing that is more suitably used in polishing for forming the wiring of a semiconductor device. In order to achieve the foregoing objective, and in accordance with the present invention, a method of polishing an object having a conductor layer made of copper or a copper alloy, the method characterized by: preparing a polishing composition containing: colloidal silica abrasive grains; a polishing accelerator; a water-soluble polymer including a constitutional unit originating from a polymerizable compound having a guanidine structure; and an oxidant; and using the polishing composition to polish a surface of the object.

The polymerizable compound having a guanidine structure is preferably a compound represented by the following general formula (1) or (2) and particularly preferably dicyandiamide.

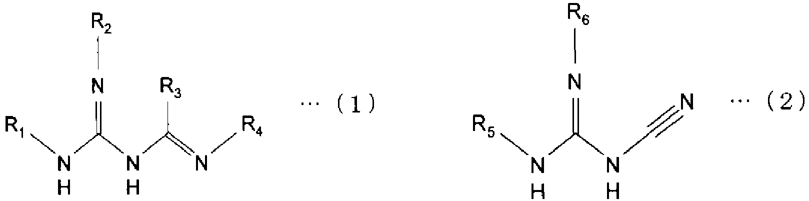

In the general formulas (1) and (2), R₁, R₂, R₃, R₄, R₅ and R₆ each represent independently a hydrogen atom, a hydroxyl group, an amino group, a carboxyl group, a phenyl group, an acetyl group, or an unsubstituted or substituted alkyl group having 1 to 4 carbon atoms.

The water-soluble polymer may be a polymer including a constitutional unit originating from dicyandiamide and a constitutional unit originating from formaldehyde, a diamine, or a polyamine.

Other aspects and advantages of the invention will become apparent from the following description illustrating by way of example the principles of the invention.

### DETAILED DESCRIPTION OF THE PREFERRED EMBODIMENTS

Hereinafter, one embodiment of the present invention will be described.

A polishing composition according to the present embodiment is prepared by mixing in water a polishing accelerator, a specific water-soluble polymer, and an oxidant, preferably together with abrasive grains and a protective film forming agent. Therefore, the polishing composition contains a polishing accelerator, a specific water-soluble polymer, and an oxidant, and preferably further contains abrasive grains and a protective film forming agent.

In general, in forming the wiring of a semiconductor device, first, a barrier layer and a conductor layer are sequentially formed in this order on an insulator layer having trenches. Subsequently, at least a portion of the conductor layer positioned outside the trenches, an outer portion of the conductor layer, and a portion of the barrier layer positioned outside the trenches, an outer portion of the barrier layer, are removed by chemical mechanical polishing. The polishing for removing at least the outer portion of the conductor layer and the outer portion of the barrier layer is usually performed by two separate steps, namely, a first polishing step and a second polishing step. In the first polishing step, the outer portion of the conductor layer is partially removed to expose the upper surface of the barrier layer. In the following second polishing step, at least the remnant of the outer portion of the conductor layer and the outer portion of the barrier layer are removed to expose the insulator layer and obtain a flat surface. The polishing composition of the present embodiment is used mainly in such polishing for forming the wiring of a semiconductor device, in particular, in the second polishing step. Specifically, the polishing composition is used mainly in the application for forming the wiring of a semiconductor device by polishing the surface of an object to be polished having a conductor layer. In the case where the wiring of a semiconductor device is formed with chemical mechanical polishing, particularly when the conductor layer is made of copper or a copper alloy, unintended inconvenient depressions may form beside the formed wiring lines. However, the polishing composition of the present embodiment can inhibit the formation of depressions beside the wiring lines. Therefore, the polishing composition is particularly useful in the case where the conductor layer is made of copper or a copper alloy.

### (Polishing Accelerator)

A polishing accelerator contained in the polishing composition has a function of chemically etching the surface of an object to be polished, and improves the rate of polishing the object to be polished by the polishing composition.

The polishing accelerator to be used may be any of an inorganic acid, an organic acid, an amino acid, and a chelating agent; however, the polishing accelerator is preferably an amino acid or a chelating agent.

Specific examples of the inorganic acid include sulfuric acid, nitric acid, boric acid, carbonic acid, hypophosphorous acid, phosphorous acid, and phosphoric acid.

Examples of the organic acid include formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, lactic acid, and an organic sulfuric acid such as methanesulfonic acid, ethanesulfonic acid, and isethionic acid.

An ammonium or alkali metal salt of an inorganic or organic acid may be used in place of an inorganic or organic acid, or in combination with an inorganic or organic acid. A combination of a weak acid and a strong base, a combination of a strong acid and a weak base, and a combination of a weak acid and a weak base are expected to have a pH buffering effect.

Specific examples of the amino acid include glycine, α-alanine, β-alanine, N-methylglycine, N,N-dimethylglycine, 2-aminobutyric acid, norvaline, valine, leucine, norleucine, isoleucine, phenylalanine, proline, sarcosine, ornithine, lysine, taurine, serine, threonine, homoserine, tyrosine, bicine, tricine, 3,5-diiodotyrosine, β-(3,4-dihydroxyphenyl)alanine, thyroxine, 4-hydroxyproline, cysteine, methionine, ethionine, lanthionine, cystathionine, cystine, cysteic acid, aspartic acid, glutamic acid, S-(carboxymethyl)cysteine, 4-aminobutyric acid, asparagine, glutamine, azaserine, arginine, canavanine, citrulline, δ-hydroxylysine, creatine, histidine, 1-methylhistidine, 3-methylhistidine, and tryptophan. Among these, glycine, N-methylglycine, N,N-dimethylglycine, α-alanine, β-alanine, bicine, and tricine are preferable, and glycine is particularly preferable.

Specific examples of the chelating agent include nitrilotriacetic acid, diethylenetriamine pentaacetic acid, ethylenediamine tetraacetic acid, N,N,N-trimethylene phosphonic acid, ethylenediamine-N,N,N',N'-tetramethylene sulfonic acid, transcyclohexanediamine tetraacetic acid, 1,2-diaminopropane tetraacetic acid, glycoletherdiamine tetraacetic acid, ethylenediamineorthohydroxyphenyl acetic acid, ethylenediaminesuccinic acid (SS isomer), N-(2-carboxylatoethyl)-L-aspartic acid, β-alanine diacetic acid, 2-phosphonobutane-1,2,4-tricarboxylic acid, 1-hydroxyethylidene-1,1-diphosphonic acid, N,N'-bis(2-hydroxybenzyl)ethylenediamine-N,N'-diacetic acid, and 1,2-dihydroxybenzene-4,6-disulfonic acid.

The content of the polishing accelerator in the polishing composition is preferably 0.01 g/L or more, more preferably 0.1 g/L or more, and further preferably 1 g/L or more. As the content of the polishing accelerator increases, the rate of polishing an object to be polished by the polishing composition is more increased.

The content of the polishing accelerator in the polishing composition is also preferably 50 g/L or less, more preferably 30 g/L or less, and further preferably 15 g/L or less. As the content of the polishing accelerator decreases, excessive etching of the surface of the object to be polished due to the polishing accelerator becomes less likely to occur.

### (Water-Soluble Polymer)

A water-soluble polymer contained in the polishing composition functions to inhibit, by forming a protective film on the surface of the conductor layer of an object to be polished, the formation of depressions beside the wiring lines formed by polishing the object with the polishing composition.

The water-soluble polymer to be used is a polymer including a constitutional unit originating from a polymerizable compound having a guanidine structure. The water soluble polymer may further include one or more constitutional units originating from other polymerizable compounds, in addition to the constitutional unit originating from a polymerizable compound having a guanidine structure. In other words, the water-soluble polymer to be used is a water-soluble polymer obtained by homopolymerization of a polymerizable compound having a guanidine structure or by copolymerization of the polymerizable compound having a guanidine structure with one or more other polymerizable compounds.

The water-soluble polymer to be used including a constitutional unit originating from a polymerizable compound having a guanidine structure may be a water-soluble polymer synthesized with such a known method as disclosed in Japanese Laid-Open Patent Publication No. 4-45148 (applicant: Sanyo Kasei Kogyo Co., Ltd.), Japanese Laid-Open Patent Publication No. 6-172615 (applicant: Mitsui Toatsu Chemical Co., Ltd.), or Japanese Laid-Open Patent Publication No. 2001-234155 (applicant: Senka Corp.), or a commercially available water-soluble polymer. For example, the following are usable: Unisence KHP 10P and Unisence KHF 10P manufactured by Senka Corp.; Neofix RP70 and Neofix FY manufactured by Nicca Chemical Co., Ltd.; and Nicafloc D-100 manufactured by Nippon Carbide Industries Co., Ltd.

The water-soluble polymer including a constitutional unit originating from a polymerizable compound having a guanidine structure is considered to form a protective film through adsorption to the surface of the conductor layer of the object to be polished by making use of the nitrogen atoms of the water-soluble polymer itself as adsorption sites. In the constitutional unit originating from a polymerizable compound having a guanidine structure, there are portions high in the density of the nitrogen atoms to function as the adsorption sites of the water-soluble polymer. Therefore, as compared to other water-soluble polymers, the water-soluble polymer can form a protective film more reliably on the surface of the conductor layer of the object to be polished, inclusive of the vicinity of the vertical boundary between the conductor layer and the insulator layer. It is considered that herewith the surface of the conductor layer in the vicinity of the vertical boundary between the conductor layer and the insulator layer comes to be insubstantially corroded during polishing, and consequently the formation of depressions beside the wiring lines is inhibited.

When the water-soluble polymer includes, in addition to a constitutional unit originating from a polymerizable compound having a guanidine structure, one or more constitutional units originating from other polymerizable compounds, the portions high in the density of the nitrogen atoms to function as adsorption sites are disposed in the molecule of the water-soluble polymer in an appropriately dispersed manner, and consequently, the adsorption of the water-soluble polymer to the abrasive grains contained in the polishing composition occurs insignificantly. This fact is favorable for the improvement of the dispersibility of the abrasive grains.

The polymerizable compound having a guanidine structure is preferably a compound represented by the following general formula (1) or (2) and particularly preferably dicyandiamide.

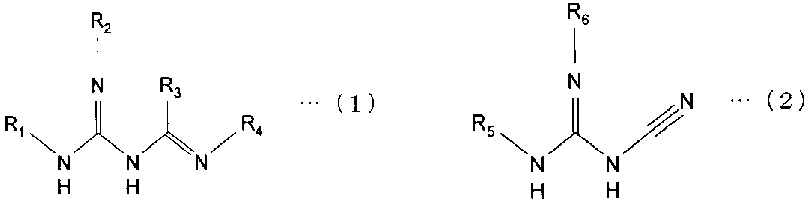

In the general formulas (1) and (2), R₁, R₂, R₃, R₄, R₅ and R₆ each represent independently a hydrogen atom, a hydroxyl group, an amino group, a carboxyl group, a phenyl group, an acetyl group, or an unsubstituted or substituted alkyl group having 1 to 4 carbon atoms. Specific examples of the unsubstituted alkyl group having 1 to 4 carbon atoms include a methyl group, an ethyl group, a propyl group, an isopropyl group, and a tertiary butyl group. Specific examples of the substituted alkyl group having 1 to 4 carbon atoms include the groups in which in each of the unsubstituted alkyl groups such as a methyl group, an ethyl group, a propyl group, an isopropyl group, and a tertiary butyl group, at least one of the hydrogen atoms is substituted with a substituent such as a hydroxyl group, an amino group, and a carboxyl group, namely, a hydroxymethyl group, a hydroxyethyl group, a hydroxypropyl group, an aminomethyl group, an aminoethyl group, a carboxymethyl group, a carboxyethyl group, a 2,3-dihydroxypropyl group, a 2-hydroxy-3-aminopropyl group, and a 3-hydroxy-2-aminopropyl group.

The molecular weight of the water-soluble polymer is preferably 500 or more, more preferably 1,000 or more, and further preferably 2,000 or more. As the molecular weight of the water-soluble polymer increases, the formation of depressions beside the wiring lines formed by polishing an object to be polished with the polishing composition is more inhibited.

The molecular weight of the water-soluble polymer is also preferably 100,000 or less, more preferably 20,000, and further preferably 10,000 or less. As the molecular weight of the water-soluble polymer decreases, the dispersibility of the abrasive grains optionally contained in the polishing composition is more improved.

The content of the water-soluble polymer in the polishing composition is preferably appropriately set according to the amount of the polishing accelerator and the amount of the oxidant contained in the polishing composition. In general, the content of the water-soluble polymer in the polishing composition is preferably 0.001 g/L or more, more preferably 0.005 g/L or more, and further preferably 0.01 g/L or more. As the content of the water-soluble polymer increases, the formation of depressions beside the wiring lines formed by polishing an object to be polished with the polishing composition is more inhibited.

The content of the water-soluble polymer in the polishing composition is also preferably 1 g/L or less, more preferably 0.5 g/L or less, and further preferably 0.2 g/L or less. As the content of the water-soluble polymer decreases, the material cost of the polishing composition is more reduced, and additionally, the occurrence of dishing on the polished surface of an object to be polished after having been polished with the polishing composition is more inhibited. The dishing refers to a phenomenon in which part of conductor layer portion that is located in the trench and essentially should not be removed is removed by polishing, and consequently the level of the upper surface of the conductor layer is lowered and thus a dish-like depression (dish) forms on the polished surface of the object to be polished.

When one or more constitutional units originating from other polymerizable compounds are further included in the water-soluble polymer, in addition to the constitutional unit originating from a polymerizable compound having a guanidine structure, such as dicyandiamide, the constitutional units originating from other polymerizable compounds are preferably the constitutional unit originating from formaldehyde, a diamine, or a polyamine. In other words, the water-soluble polymer to be used may be a water-soluble polymer obtained by copolymerizing a polymerizable compound having a guanidine structure at least with formaldehyde, a diamine, or a polyamine. Unisence KHP 10P and Neofix RP70 are each a water-soluble polymer including a constitutional unit originating from dicyandiamide and a constitutional unit originating from a polyamine, and Unisence KHF 10P, Neofix FY, and Nicafloc D-100 are each a water-soluble polymer including a constitutional unit originating from dicyandiamide and a constitutional unit originating from formaldehyde.

Specific examples of the diamine include ethylenediamine, trimethylenediamine, propylenediamine, tetramethylenediamine, pentamethylenediamine, hexamethylenediamine, heptamethylenediamine, paraphenylenediamine, N-(2-hydroxyethyl)-1,2-ethanediamine, and 2-hydroxy-1,3-propanediamine. Among these, ethylenediamine, trimethylenediamine, tetramethylenediamine, pentamethylenediamine, hexamethylenediamine, heptamethylenediamine, and paraphenylenediamine are preferable.

Specific examples of the polyamine include a polyalkylenepolyamine such as diethylenetriamine, triethylenetetramine, tetraethylenepentamine, pentaethylenehexamine, bis(3-aminopropyl)amine, bis(4-aminobutyl)amine, iminobispropylamine, methylbis(3-aminopropyl)amine, N,N'-bis(3-aminopropyl)-1,4-butanediamine, N-(3-aminopropyl)-1,4-butanediamine, and N-(4-aminobutyl)-1,4-butanediamine. Among these, diethylenetriamine, triethylenetetramine, tetraethylenepentamine, pentaethylenehexamine, and iminobispropylamine are preferable, and diethylenetriamine and triethylenetetramine are particularly preferable.

When the water-soluble polymer to be used is obtained by copolymerizing a polymerizable compound having a guanidine structure with one or more other polymerizable compounds, the ratio of the number of moles of the polymerizable compound having a guanidine structure to the number of moles of the one or more other polymerizable compounds is preferably 1/50 or more, more preferably 1/20 or more, and further preferably 1/10 or more. As the proportion of the polymerizable compound having a guanine structure increases, the formation of depressions beside the wiring lines formed by polishing an object to be polished with the polishing composition is more inhibited.

The ratio of the number of moles of the polymerizable compound having a guanidine structure to the number of moles of the one or more other polymerizable compounds is also preferably 50/1 or less, more preferably 20/1 or less, and further preferably 10/1 or less. As the proportion of the polymerizable compound having a guanidine structure decreases, the dispersibility of the abrasive grains optionally contained in the polishing composition is more improved.

### (Oxidant)

An oxidant contained in the polishing composition has a function to oxidize the surface of an object to be polished, and improves the rate of polishing the object to be polished by the polishing composition.

The oxidant to be used can be, for example, peroxide. Specific examples of the peroxide include hydrogen peroxide, peracetic acid, a percarbonate, urea peroxide, perchloric acid, and a persulfate such as sodium persulfate, potassium persulfate, and ammonium persulfate. Among these, hydrogen peroxide and a persulfate are preferable, and hydrogen peroxide is particularly preferable.

The content of the oxidant in the polishing composition is preferably 0.1 g/L or more, more preferably 1 g/L or more, and further preferably 3 g/L or more. As the content of the oxidant increases, the rate of polishing an object to be polished by the polishing composition is more increased.

The content of the oxidant in the polishing composition is also preferably 200 g/L or less, more preferably 100 g/L or less, and further preferably 40 g/L or less. As the content of the oxidant decreases, the material cost of the polishing composition is more reduced, and the load of the disposal process of the polishing composition after being used for polishing is more alleviated; and additionally, excessive oxidation of the surface of the object to be polished due to the oxidant becomes less likely to occur.

### (Abrasive Grains)

Abrasive grains contained in the polishing composition have a function to mechanically polish an object to be polished, and improve the rate of polishing the object to be polished by the polishing composition.

The abrasive grains to be used is colloidal silica.

The content of the abrasive grains in the polishing composition is preferably 0.005% by mass or more, more preferably 0.01% by mass or more, and further preferably 0.05% by mass or more. As the content of the abrasive grains increases, the rate of polishing an object to be polished by the polishing composition is more increased.

The content of the abrasive grains in the polishing composition is also preferably 5% by mass or less, more preferably 1 % by mass or less, and further preferably 0.5% by mass or less. As the content of the abrasive grains decreases, the material cost of the polishing composition is more reduced, and additionally, the occurrence of dishing on the polished surface of an object to be polished after having been polished with the polishing composition is more inhibited.

The average primary particle size of the abrasive grains is preferably 5 nm or more, more preferably 7 nm or more, and further preferably 10 nm or more. As the average primary particle size of the abrasive grains increases, the rate of polishing an object to be polished by the polishing composition is more increased.

The average primary particle size of the abrasive grains is also preferably 100 nm or less, more preferably 60 nm or less, and further preferably 40 nm or less. As the average primary particle size of the abrasive grains decreases, the occurrence of dishing on the polished surface of an object to be polished after having been polished with the polishing composition is more inhibited. The value of the average primary particle size of the abrasive grains is calculated, for example, on the basis of the specific surface area of the abrasive grains measured with the BET method.

### (Protective Film Forming Agent)

With the addition of a protective film forming agent in the polishing composition, the formation of depressions beside the wiring lines formed by polishing an object to be polished with the polishing composition is more inhibited than without the addition of the protective film forming agent. The occurrence of dishing on the polished surface of an object to be polished after having been polished with the polishing composition is also more inhibited. Therefore, the flatness of the polished surface of an object to be polished after having been polished with the polishing composition becomes more improved.

The protective film forming agent to be used is not particularly limited, but is preferably a heterocyclic compound or a surfactant. The number of the atoms in the heterocyclic ring of the heterocyclic compound is not particularly limited. The heterocyclic compound may be a single ring compound or a polycyclic compound having a condensed ring.

Specific examples of the heterocyclic compound to be used as the protective film forming agent include a nitrogen containing-heterocyclic compound such as pyrrole, a pyrazole compound, an imidazole compound, a triazole compound, a tetrazole compound, pyridine, pyrazine, pyridazine, pyrindine, indolizine, an indole compound, isoindole, an indazole compound, purine, quinolizine, quinoline, isoquinoline, naphthyridine, phthalazine, quinoxaline, quinazoline, cinnoline, pteridine, thiazole, isothiazole, oxazole, isoxazole, and furazan.

Examples of the pyrazole compound include 1H-pyrazole, 4-nitro-3-pyrazolecarboxylic acid, 3,5-pyrazolecarboxylic acid, 3-amino-5-phenylpyrazole, 5-amino-3-phenylpyrazole, 3,4,5-tribromopyrazole, 3-aminopyrazole, 3,5-dimethylpyrazole, 3,5-dimethyl-1-hydroxymethyl pyrazole, 3-methylpyrazole, 1-methylpyrazole, 3-amino-5-methylpyrazole, 4-amino-pyrazolo[3,4-d]pyrimidine, allopurinol, 4-chloro-1H-pyrazolo[3,4-d]pyrimidine, 3,4-dihydroxy-6-methyl pyrazolo(3,4-b)-pyridine, and 6-methyl-1H-pyrazolo[3,4-b]pyridine-3-amine.

Examples of the imidazole compound include imidazole, 1-methylimidazole, 2-methylimidazole, 4-methylimidazole, 1,2-dimethylimidazole, 2-ethyl-4-methylimidazole, 2-isopropylimidazole, benzimidazole, 5,6-dimethyl benzimidazole, 2-aminobenzimidazole, 2-chlorobenzimidazole, 2-methyl benzimidazole, 2-(1-hydroxyethyl)benzimidazole, 2-hydroxybenzimidazole, 2-phenyl benzimidazole, 2,5-dimethyl benzimidazole, 5-methyl benzimidazole, 5-nitrobenzimidazole, and 1H-purine.

Examples of the triazole compound include 1,2,3-triazole, 1,2,4-triazole, 1-methyl-1,2,4-triazole, methyl-1H-1,2,4-triazole-3-carboxylate, 1,2,4-triazole-3-carboxylicacid, 1,2,4-triazole-3-methyl carboxylate, 1H-1,2,4-triazole-3-thiol, 3,5-diamino-1H-1,2,4-triazole, 3-amino-1,2,4-triazole-5-thiol, 3-amino-1H-1,2,4-triazole, 3-amino-5-benzyl-4H-1,2,4-triazole, 3-amino-5-methyl-4H-1,2,4-triazole, 3-nitro-1,2,4-triazole, 3-bromo-5-nitro-1,2,4-triazole, 4-(1,2,4-triazole-1-yl)phenol, 4-amino-1,2,4-triazole, 4-amino-3,5-dipropyl-4H-1,2,4-triazole, 4-amino-3,5-dimethyl-4H-1,2,4-triazole, 4-amino-3,5-diheptyl-4H-1,2,4-triazole, 5-methyl-1,2,4-triazole-3,4-diamine, 1H-benzotriazole, 1-hydroxybenzotriazole, 1-aminobenzotriazole, 1-carboxybenzotriazole, 5-chloro-1H-benzotriazole, 5-nitro-1H-benzotriazole, 5-carboxy-1H-benzotriazole, 5-methyl-1H-benzotriazole, 5,6-dimethyl-1H-benzotriazole, 1-(1',2'-dicarboxyethyl)benzotriazole, 1-[N,N-bis(hydroxyethyl)aminomethyl]benzotriazole, 1-[N,N-bis(hydroxyethyl)aminomethyl]-5-methylbenzotriazole, and 1-[N,N-bis(hydroxyethyl)aminomethyl]-4-methylbenzotriazole.

Examples of the tetrazole compound include 1H-tetrazole, 5-methyltetrazole, 5-aminotetrazole, and 5-phenyltetrazole.

Examples of the indazole compound include 1H-indazole, 5-amino-1H-indazole, 5-nitro-1H-indazole, 5-hydroxy-1H-indazole, 6-amino-1H-indazole, 6-nitro-1H-indazole, 6-hydroxy-1H-indazole, and 3-carboxy-5-methyl-1H-indazole.

Examples of the indole compound include 1H-indole, 1-methyl-1H-indole, 2-methyl-1H-indole, 3-methyl-1H-indole, 4-methyl-1H-indole, 5-methyl-1H-indole, 6-methyl-1H-indole, 7-methyl-1H-indole, 4-amino-1H-indole, 5-amino-1H-indole, 6-amino-1H-indole, 7-amino-1H-indole, 4-hydroxy-1H-indole, 5-hydroxy-1H-indole, 6-hydroxy-1H-indole, 7-hydroxy-1H-indole, 4-methoxy-1H-indole, 5-methoxy-1H-indole, 6-methoxy-1H-indole, 7-methoxy-1H-indole, 4-chloro-1H-indole, 5-chloro-1H-indole, 6-chloro-1H-indole, 7-chloro-1H-indole, 4-carboxy-1H-indole, 5-carboxy-1H-indole, 6-carboxy-1H-indole, 7-carboxy-1H-indole, 4-nitro-1H-indole, 5-nitro-1H-indole, 6-nitro-1H-indole, 7-nitro-1H-indole, 4-cyano-1H-indole, 5-cyano-1H-indole, 6-cyano-1H-indole, 7-cyano-1H-indole, 2,5-dimethyl-1H-indole, 1,2-dimethyl-1H-indole, 1,3-dimethyl-1H-indole, 2,3-dimethyl-1H-indole, 5-amino-2,3-dimethyl-1H-indole, 7-ethyl-1H-indole, 5-(aminomethyl)indole, 2-methyl-5-amino-1H-indole, 3-hydroxymethyl-1H-indole, 6-isopropyl-1H-indole, and 5-chloro-2-methyl-1H-indole.

Preferable heterocyclic compounds among these are the compounds having a triazole skeleton; in particular, 1H-benzotriazole, 5-methyl-1H-benzotriazole, 5,6-dimethyl-1H-benzotriazole, 1-[N,N-bis(hydroxyethyl)aminomethyl]-5-methylbenzotriazole, 1-[N,N-bis(hydroxyethyl)aminomethyl]-4-methylbenzotriazole, 1,2,3-triazole, and 1,2,4-triazole are particularly preferable. These heterocyclic compounds each have a high chemical or physical adsorbability to the surface of an object to be polished, and hence each form a stronger protective film on the surface of the object to be polished. This fact is favorable for the improvement of the flatness of the polished surface of an object to be polished after having been polished with the polishing composition.

The surfactant to be used as the protective film forming agent may be any of an anionic surfactant, a cationic surfactant, an amphoteric surfactant, and a nonionic surfactant.

Examples of the anionic surfactant include a polyoxyethylene alkyl ether acetic acid, a polyoxyethylene alkyl sulfuric acid ester, an alkyl sulfuric acid ester, a polyoxyethylene alkyl sulfuric acid, an alkyl sulfuric acid, an alkylbenzenesulfonic acid, an alkylphosphoric acid ester, a polyoxyethylene alkylphosphoric acid ester, a polyoxyethylene sulfosuccinic acid, an alkylsulfosuccinic acid, an alkylnaphthalenesulfonic acid, and an alkyldiphenyl ether disulfonic acid, and salts of these substances.

Examples of the cationic surfactant include an alkyltrimethylammonium salt, an alkyldimethylammonium salt, an alkylbenzyldimethylammonium salt, and an alkylamine salt.

Examples of the amphoteric surfactant include an alkyl betaine and an alkyl amine oxide.

Examples of the nonionic surfactant include a polyoxyethylene alkyl ether, a polyoxyalkylene alkyl ether, a sorbitan fatty acid ester, a glycerin fatty acid ester, a polyoxyethylene fatty acid ester, a polyoxyethylene alkyl amine, and an alkyl alkanol amide.

Preferable surfactants among these are a polyoxyethylene alkyl ether acetic acid, a polyoxyethylene alkyl ether sulfate, an alkyl ether sulfate, an alkylbenzenesulfonate, and a polyoxyethylene alkyl ether. These surfactants each have a high chemical or physical adsorbability to the surface of an object to be polished, and hence each form a stronger protective film on the surface of the object to be polished. This fact is favorable for the improvement of the flatness of the polished surface of an object to be polished after having been polished with the polishing composition.

The content of the protective film forming agent in the polishing composition is preferably 0.001 g/L or more, more preferably 0.005 g/L or more, and further preferably 0.01 g/L or more. As the content of the protective film forming agent increases, the flatness of the polished surface of an object to be polished after having been polished with the polishing composition becomes more improved.

The content of the protective film forming agent in the polishing composition is also preferably 10 g/L or less, more preferably 5 g/L or less, and further preferably 1 g/L or less. As the content of the protective film forming agent decreases, the rate of polishing an object to be polished by the polishing composition is more increased.

### (pH of Polishing Composition)

The pH of the polishing composition is preferably 3 or more and more preferably 5 or more. As the pH of the polishing composition increases, excessive etching of the surface of an object to be polished due to the polishing composition becomes less likely to occur.

The pH of the polishing composition is also preferably 9 or less and more preferably 8 or less. As the pH of the polishing composition decreases, the formation of depressions beside the wiring lines formed by polishing an object to be polished with the polishing composition is more inhibited.

For the purpose of obtaining the intended pH, an optional alkali, an optional acid, or an optional buffer agent may be used.

According to the present embodiment, the following advantages are obtained.

The polishing composition of the present embodiment includes a water-soluble polymer including a constitutional unit originating from a polymerizable compound having a guanidine structure. Due to the function of the water-soluble polymer, it is possible to inhibit the formation of depressions beside the wiring lines of a semiconductor device formed by polishing an object to be polished with the polishing composition. Therefore, the polishing composition is suitable for use in polishing for forming the wiring of a semiconductor device.

The embodiment may be modified as follows.

The polishing composition of the embodiment may contain two or more polishing accelerators.

The polishing composition of the embodiment may include two or more water-soluble polymers. In this case, some of the water-soluble polymers are each not necessarily required to be a water-soluble polymer including a constitutional unit originating from a polymerizable compound having a guanidine structure. Specific examples of such a water-soluble polymer include a polysaccharide such as alginic acid, pectic acid, carboxymethyl cellulose, curdlan, and pullulan; a polycarboxylic acid and a salt thereof; a vinyl polymer such as polyacrylamide, polyvinyl alcohol, polyvinylpyrrolidone, and polyacrolein; polyglycerin; and a polyglycerin ester. When a water-soluble polymer not including a constitutional unit originating from a polymerizable compound having a guanidine structure is added to the polishing composition, the following advantage are attained: the water-soluble polymer adsorbs to the surface of the abrasive grains or the surface of the object to be polished, and hence it is possible to control the rate of polishing the object to be polished by the polishing composition; and additionally, the water-soluble polymer stabilizes, in the polishing composition, the insoluble components produced in the course of the polishing.

The polishing composition of the embodiment may contain two or more oxidants.

The polishing composition of the embodiment may contain two or more types of abrasive grains.

The polishing composition of the embodiment may contain two or more protective film forming agents. In this case, for example, two or more heterocyclic compounds may be used, or two or more surfactants may be used. Alternatively, a heterocyclic compound and a surfactant may be used in combination. When a heterocyclic compound and a surfactant are used in combination, that is, when the polishing composition contains a heterocyclic compound and a surfactant, it is easy to establish the compatibility between the improvement of the rate of polishing the object to be polished by the polishing composition and the improvement of the flatness of the polished surface of the object to be polished after having been polished with the polishing composition.

The polishing composition of the embodiment may further contain, where necessary, a known additive such as a preservative or a fungicide. Specific examples of the preservative and the fungicide include an isothiazoline fungicide such as 2-methyl-4-isothiazolin-3-one and 5-chloro-2-methyl-4-isothiazolin-3-one; a paraoxybenzoic acid ester; and pehnoxyethanol.

The polishing composition of the embodiment may be of a one-part type or of a multi-part type including a two-part type.

The polishing composition of the embodiment may be prepared by diluting, for example, by a factor of 10 or more, an undiluted solution of a polishing composition with a diluting liquid such as water.

The polishing composition of the embodiment may be used for the purposes other than the polishing for forming the wiring of a semiconductor device.

Next, Examples and Comparative Examples of the present invention are described.

A polishing composition of each of Examples 1 to 17 and Comparative Examples 4 to 22 was prepared by mixing in water a polishing accelerator, a water-soluble polymer or an alternative compound, an oxidant, abrasive grains, and a protective film forming agent. A polishing composition of each of Comparative Examples 1 to 3 was prepared by mixing in water a polishing accelerator, an oxidant, abrasive grains, and a protective film forming agent. The details of the water-soluble polymers or the alternative compounds in the polishing compositions of Examples 1 to 17 and Comparative Examples 1 to 22 are shown in Tables 1 and 2. Although not shown in Tables 1 and 2, each of the polishing compositions of Examples 1 to 17 and Comparative Examples 1 to 22 contained 10 g/L of glycine as a polishing accelerator, 15 g/L of hydrogen peroxide as an oxidant, and 0.1 % by mass of colloidal silica having an average primary particle size of 30 nm as abrasive grains. Each of the polishing compositions of Examples 1 to 17 and Comparative Examples 1 to 22 further contained as a protective film forming agent 0.08 g/L of a mixture composed of 1-[N,N-bis(hydroxyethyl)aminomethyl]-5-methylbenzotriazole and 1-[N,N-bis(hydroxyethyl)aminomethyl]-4-methylbenzotriazole, 0.1 g/L of ammonium lauryl ether sulfate, and 0.5 g/L of polyoxyethylene alkyl ether. Some of the polishing compositions also each contained a further additional protective film forming agent. The details of the additional protective film forming agents contained in some of the polishing compositions are also shown in Tables 1 and 2.

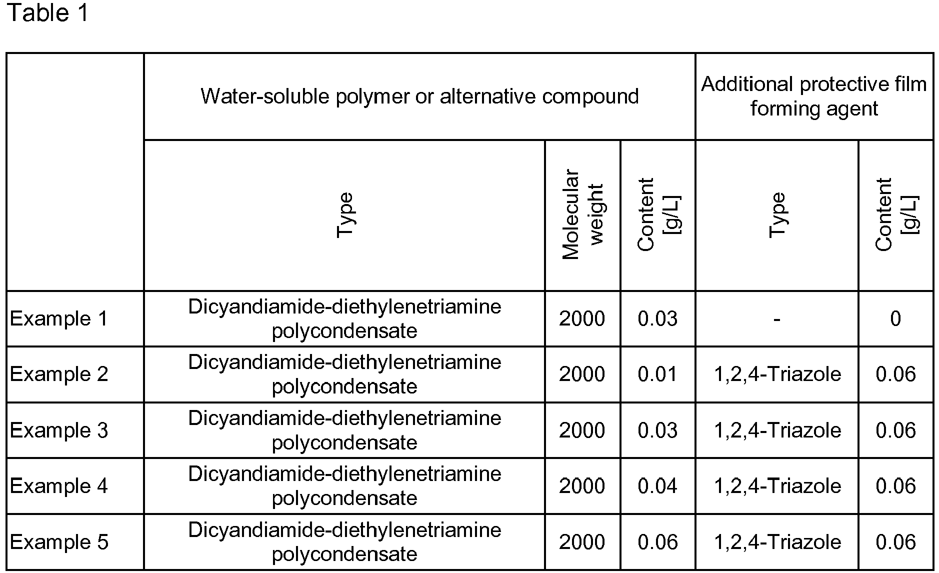

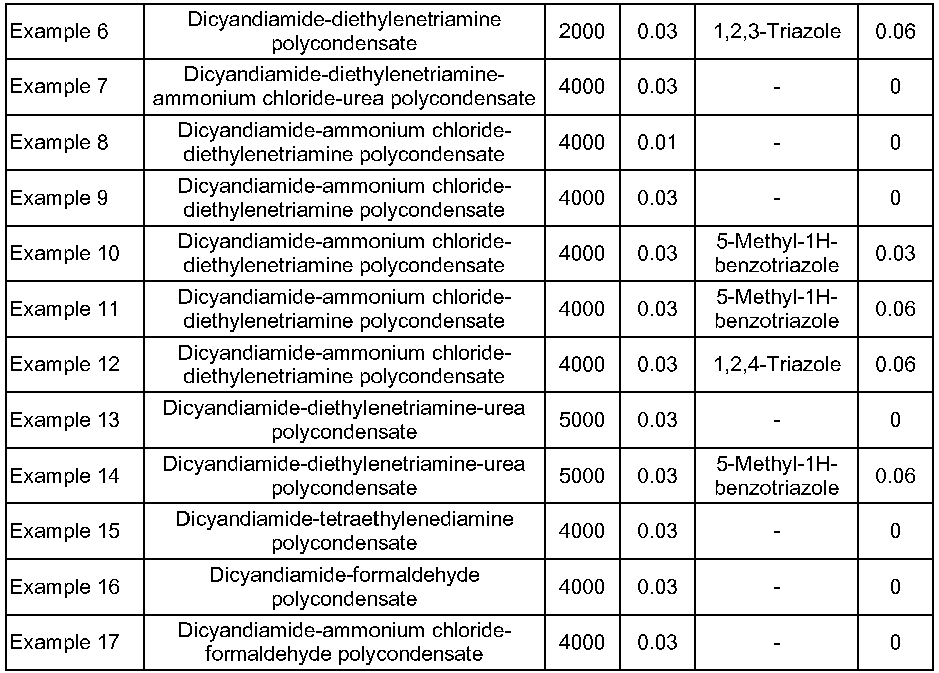

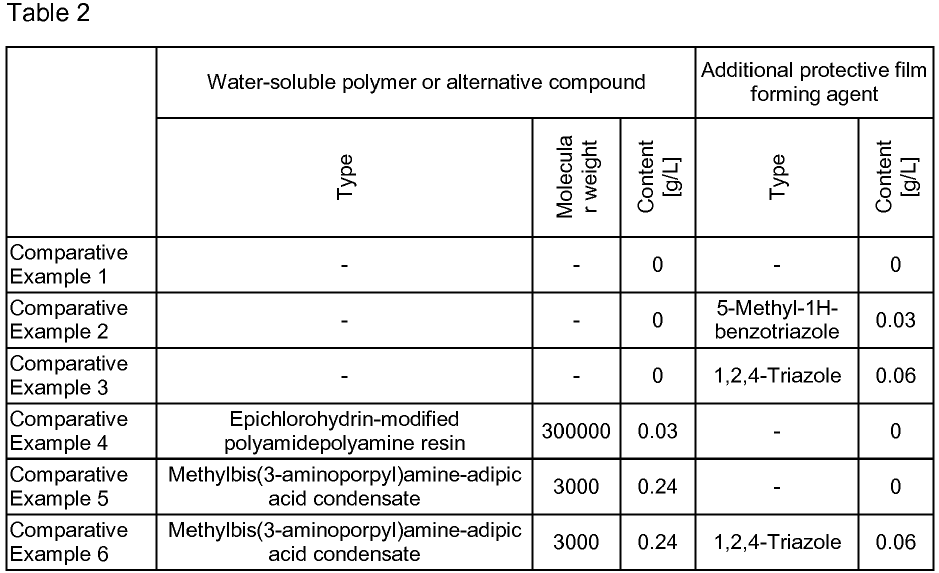

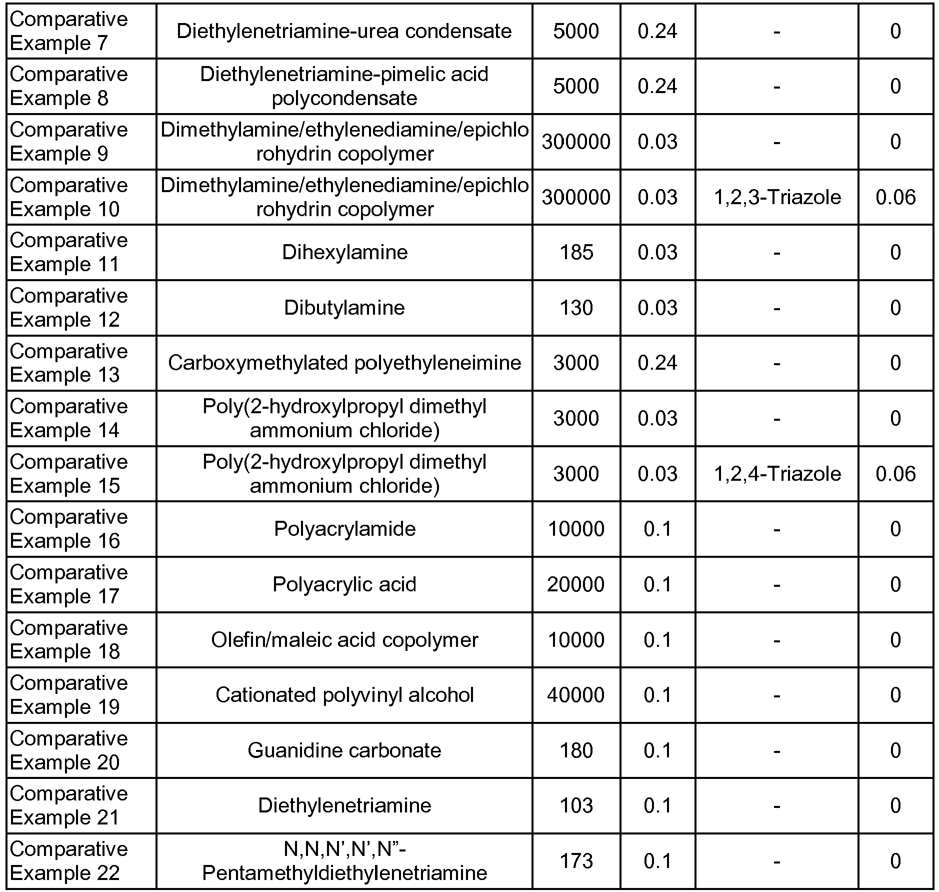

### <Depressions beside Wiring Lines>

In each of Examples and Comparative Examples, the surface of a copper pattern wafer (manufactured by ATDF, Inc.; mask pattern 754; copper film thickness before polishing: 700 nm; trench depth: 300 nm) was polished by using the polishing composition, under the first polishing conditions specified in Table 3, until the copper film thickness came to be 250 nm. Then, the surface of the copper pattern wafer after having been polished was polished by using the same polishing composition, under the second polishing conditions specified in Table 4, until the barrier film was exposed. The surface of the copper pattern wafer having been subjected to the two-step polishing as described above was observed by using a review SEM (RS-4000, manufactured by Hitachi High-Technologies Co., Ltd.), the formation/non-formation of depressions beside the wiring lines was examined in the area in which wiring lines of 0.18 µm in width and insulating portions of 0.18 µm in width were alternately aligned and in the area in which wiring lines of 100 µm in width and insulating portions of 100 µm in width were alternately aligned. Accordingly, the case where no depressions beside the wiring lines were identified in both of the areas was rated as excellent; the case where depressions of less than 5 nm in width, beside the wiring lines were identified only in either one of the areas was rated as good; the case where the depressions of less than 5 nm in width, beside the wiring lines were identified in both of the areas was rated as fair; the case where depressions of 5 nm or more and less than 20 nm in width, beside the wiring lines were identified at least in either one of the areas was rated as slightly poor; and the case where depressions of 20 nm or more in width, beside the wiring lines were identified at least in either one of the areas was rated as poor. The evaluation results thus obtained are shown in the columns each with the heading of "depressions beside wiring lines" in Tables 5 and 6.

### <Rate of Polishing>

In each of Examples and Comparative Examples, the surface of a copper blanket wafer was polished by using the polishing composition, for 60 seconds under the first polishing conditions specified in Table 3 and for 60 seconds under the second polishing conditions specified in Table 4; the rates of polishing thus obtained respectively under the first polishing conditions and the second polishing conditions are shown in the columns with the heading of "rates of polishing" in Tables 5 and 6. The value of each of the rates of polishing was obtained by dividing the thickness difference of the copper blanket wafer between before and after the polishing by the polishing time, where the thickness of the copper blanket wafer was measured with a sheet resistance meter "VR-120SD/8" manufactured by Hitachi Kokusai Electric Inc.

### <Storage Stability>

In each of Examples and Comparative Examples, the polishing composition after having been stored at 60°C for 1 week was cooled down to room temperature, and was subjected to the evaluation of depressions beside the wiring lines and the measurement of the rates of polishing in the same manners as described above; and the results thus obtained were compared with the corresponding results for the polishing composition before the storage. For the purpose of evaluating the dispersibility of the abrasive grains, in each of Examples and Comparative Examples, the polishing composition after having been stored at 60°C for 1 week was cooled down to room temperature in the same manner as described above; then, the transmittance of the polishing composition in the wavelength region from 190 nm to 900 nm was measured with a spectrophotometer "UV-2450" manufactured by Shimadzu Corp., and the results thus obtained were compared with the corresponding results for the polishing composition before the storage. Accordingly, the case where the evaluation result of the depressions beside the wiring lines, the measurement result of the rates of polishing, and the evaluation result of the dispersibility of the abrasive grains were all almost the same between before and after the storage was rated as excellent; the case where the evaluation result of the depressions beside the wiring lines and the evaluation result of the dispersibility of the abrasive grains were almost the same between before and after the storage, but the rate of polishing was decreased after the storage by 5% or more and less than 10% was rated as good ; the case where the measurement result of the rates of polishing and the evaluation result of the dispersibility of the abrasive grains were almost the same between before and after the storage, but the evaluation result of the depressions beside the wiring lines was degraded by one grade after the storage was rated as fair; the case where the evaluation result of the dispersibility of the abrasive grains was found to be worse after the storage was rated as slightly poor; and the case where the value of the rates of polishing was decreased after the storage by 10% or more, or the evaluation result of the depressions beside the wiring lines was degraded by two or more grades was rated as poor. The results thus obtained are shown in the columns each with the heading of "storage stability" in Tables 5 and 6.

### <Surface Roughness>

In each of Examples and Comparative Examples, the surface of a copper pattern wafer (manufactured by ATDF, Inc.; mask pattern 754; copper film thickness before polishing: 700 nm; trench depth: 300 nm) was polished by using the polishing composition, under the first polishing conditions specified in Table 3, until the copper film thickness came to be 250 nm. Then, the surface of the copper pattern wafer after having been polished was polished by using the same polishing composition, under the second polishing conditions specified in Table 4, until the barrier film was exposed. The surface roughness Ra in the vicinity of the central portion of the isolated wiring portion of 100 µm in width in the copper pattern wafer having been subjected to the two-step polishing as described above was measured with the scanning probe microscope "S-image" manufactured by SII Nano Technology Inc. The measurement of the surface roughness Ra was performed with a Si probe in the DFM mode, at 256 x 256 points (256 points in the longitudinal direction times 256 points in the lateral direction) in a 1-µm square area at a scanning rate of 0.5 Hz. The case where the measured Ra value was less than 0.5 nm was rated as good ; the case where the measured Ra value was 0.5 nm or more and less than 1.0 nm was rated as slightly poor; and the case where the measured Ra value was 1.0 nm or more was rated as poor. The evaluation results thus obtained are shown in the columns each with the heading of "surface roughness" in Tables 5 and 6.

### <Dishing>

In each of Examples and Comparative Examples, the surface of a copper pattern wafer (manufactured by ATDF, Inc.; mask pattern 754; copper film thickness before polishing: 700 nm; trench depth: 300 nm) was polished by using the polishing composition, under the first polishing conditions specified in Table 3, until the copper film thickness came to be 250 nm. Then, the surface of the copper pattern wafer after having been polished was polished by using the same polishing composition, under the second polishing conditions specified in Table 4, until the barrier film was exposed. The dishing magnitude (dishing depth) in the copper pattern wafer having been subjected to the two-step polishing as described above, more specifically the dishing magnitude in a first area in which wiring lines of 9 µm in width and insulating films of 1 µm in width were alternately aligned and the dishing magnitude in a second area in which wiring lines of 5 µm in width and insulating films of 1 µm in width were alternately aligned were measured with the wide area AFM "WA-1300" manufactured by Hitachi Kenki Fine Tech Co., Ltd. The measurement results thus obtained are shown in the columns each with the heading of "dishing" in Tables 5 and 6.

**Table 3**

| <First Polishing Conditions> |
|---|
| Polishing machine: Single-sided CMP polishing machine (Reflexion LK, manufactured by Applied Materials Inc.) |
| Polishing Pad: Foamed polyurethane pad |
| Polishing pressure: 2.7 psi (= ca. 18.6 kPa) |
| Surface plate rotational rate: 90 rpm |
| Polishing composition feed rate: 300 mL/min |
| Carrier rotational rate: 90 rpm |

**Table 4**

| <Second Polishing Conditions> |
|---|
| Polishing machine: Single-sided CMP polishing machine (Reflexion LK, manufactured by Applied Materials Inc.) |
| Polishing Pad: Foamed polyurethane pad |
| Polishing pressure: 1.5 psi (= ca. 10.3 kPa) |
| Surface plate rotational rate: 90 rpm |
| Polishing composition feed rate: 300 mL/min |
| Carrier rotational rate: 90 rpm |

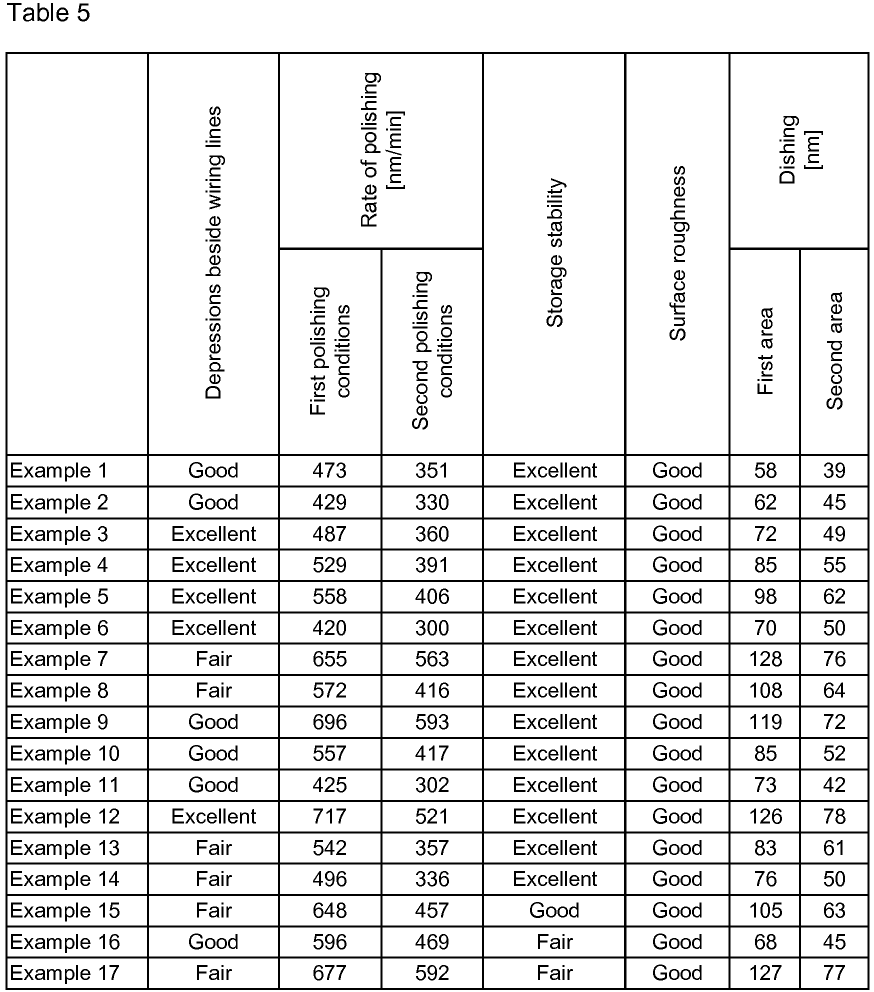

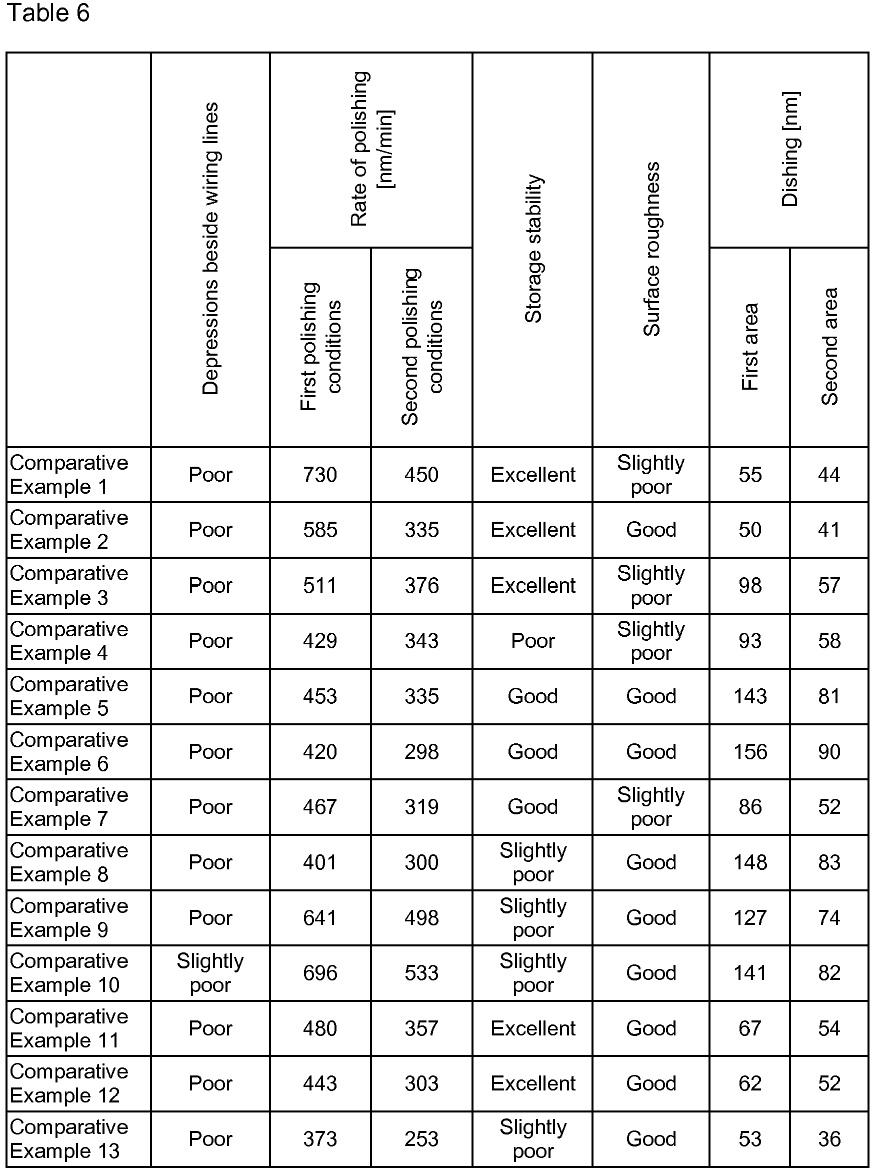

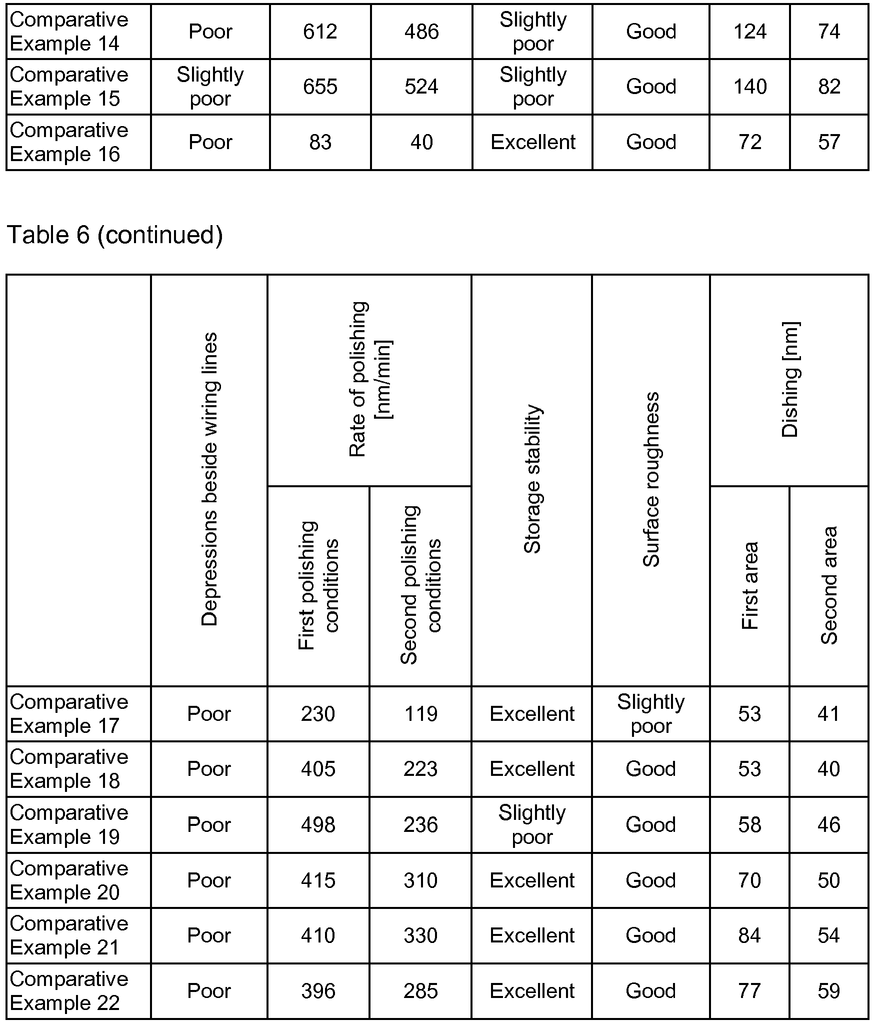

## Claims

1. A method of polishing an object having a conductor layer made of copper or a copper alloy, the method **characterized by**:
preparing a polishing composition containing:
colloidal silica abrasive grains;
a polishing accelerator;
a water-soluble polymer including a constitutional unit originating from a polymerizable compound having a guanidine structure; and
an oxidant; and
using the polishing composition to polish a surface of the object.

2. The method according to claim 1, wherein the polymerizable compound having a guanidine structure is a compound represented by the following general formula (1) or (2), 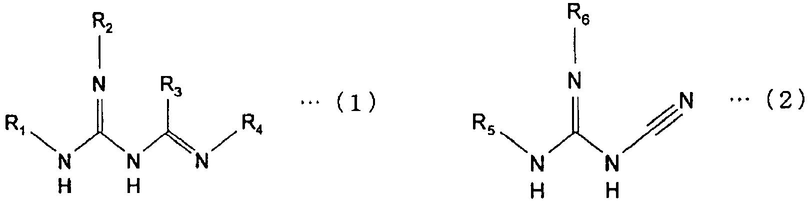 where, R1, R2, R3, R4, R5 and R6 each represent independently a hydrogen atom, a hydroxyl group, an amino group, a carboxyl group, a phenyl group, an acetyl group, or an unsubstituted or substituted alkyl group having 1 to 4 carbon atoms.

3. The method according to claim 1 or 2, wherein the water-soluble polymer includes a constitutional unit originating from dicyandiamide, which is a polymerizable compound having a guanidine structure, and a constitutional unit originating from formaldehyde.

4. The method according to any one of claims 1 to 3, wherein the water-soluble polymer includes a constitutional unit originating from dicyandiamide and a constitutional unit originating from a diamine or a polyamine.

5. The method according to any one of claims 1 to 4, wherein the polishing accelerator is an amino acid or a chelating agent.

6. The method according to any one of claims 1 to 5, wherein the oxidant is hydrogen peroxide.

7. The method according to any one of claims 1 to 6, further comprising a protective film forming agent, wherein the protective film forming agent is a heterocyclic compound or a surfactant.

## Patentansprüche

1. Verfahren zum Polieren eines Gegenstands mit einer Leiterschicht aus Kupfer oder einer Kupferlegierung, wobei das Verfahren **gekennzeichnet ist durch**:
Zubereiten einer Polierzusammensetzung enthaltend:
kolloidale Siliziumoxid-Schleifinittelkörner;
einen Polierbeschleuniger;
ein wasserlösliches Polymer einschließlich einer Struktureinheit ausgehend von einer polymerisierbaren Verbindung mit einer Guanidinstruktur; und
ein Oxidationsmittel; und
Verwenden der Polierzusammensetzung zum Polieren einer Oberfläche des Gegenstands.

2. Verfahren nach Anspruch 1, worin die polymerisierbare Verbindung mit einer Guanidinstruktur eine Verbindung ist, die durch die folgende generelle Formel (1) oder (2) dargestellt wird, 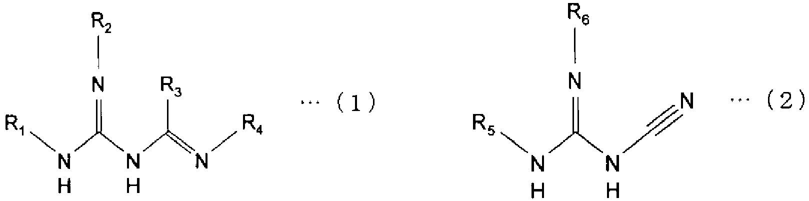 worin R1, R2, R3, R4, R5 und R6 je unabhängig voneinander ein Wasserstoffatom, eine Hydroxylgruppe, eine Aminogruppe, eine Carboxylgruppe, eine Phenylgruppe, eine Acetylgruppe, oder eine unsubstituierte oder substituierte Alkylgruppe mit 1 bis 4 Kohlenstoffatomen darstellen.

3. Verfahren nach Anspruch 1 oder 2, worin das wasserlösliche Polymer eine Struktureinheit ausgehend von Diacyanamid, welches eine polymerisierbare Verbindung mit einer Guanidinstruktur ist, und eine Struktureinheit ausgehend von Formaldehyd einschließt.

4. Verfahren nach einem der Ansprüche 1 bis 3, worin das wasserlösliche Polymer eine Struktureinheit ausgehend von Dicyanamid und eine Struktureinheit ausgehend von einem Diamin oder einem Polyamin einschließt.

5. Verfahren nach einem der Ansprüche 1 bis 4, worin der Polierbeschleuniger eine Aminosäure oder ein Chelatbildner ist.

6. Verfahren nach einem der Ansprüche 1 bis 5, worin das Oxidationsmittel Wasserstoffperoxid ist.

7. Verfahren nach einem der Ansprüche 1 bis 6, weiterhin umfassend ein Schutzfilmbildendes Mittel, worin das Schutzfilm-bildende Mittel eine heterozyklische Verbindung oder ein Tensid ist.

## Revendications

1. Procédé de polissage d'un objet présentant une couche conductrice composée de cuivre ou d'un alliage de cuivre, le procédé étant **caractérisé par** :
la préparation d'une composition de polissage contenant :
des grains abrasifs de silice colloïdale ;
un accélérateur de polissage ;
un polymère hydrosoluble incluant une unité constitutive provenant d'un composé polymérisable ayant une structure de guanidine ; et
un oxydant ; et
l'utilisation de la composition de polissage pour polir une surface de l'objet.

2. Le procédé selon la revendication 1, sachant que le composé polymérisable ayant une structure de guanidine est un composé représenté par la formule générale (1) ou (2) suivante, 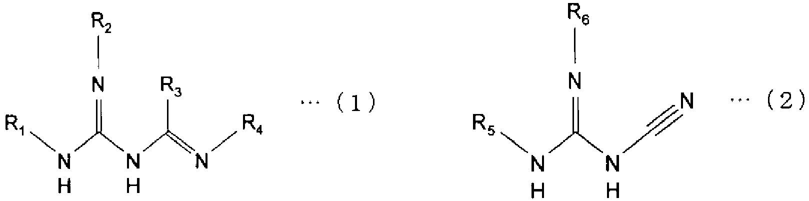 où R1, R2, R3, R4, R5 et R6 représentent chacun indépendamment un atome d'hydrogène, un groupe hydroxyle, un groupe amino, un groupe carboxyle, un groupe phényle, un groupe acétyle, ou un groupe alkyle non substitué ou substitué ayant 1 à 4 atomes de carbone.

3. Le procédé selon la revendication 1 ou 2, sachant que le polymère hydrosoluble inclut une unité constitutive provenant du dicyandiamide, lequel est un composé polymérisable ayant une structure de guanidine, et une unité constitutive provenant du formaldéhyde.

4. Le procédé selon l'une quelconque des revendications 1 à 3, sachant que le polymère hydrosoluble inclut une unité constitutive provenant du dicyandiamide et une unité constitutive provenant d'un diamine ou d'un polyamine.

5. Le procédé selon l'une quelconque des revendications 1 à 4, sachant que l'accélérateur de polissage est un acide aminé ou un agent chélatant.

6. Le procédé selon l'une quelconque des revendications 1 à 5, sachant que l'oxydant est du péroxyde d'hydrogène.

7. Le procédé selon l'une quelconque des revendications 1 à 6, comprenant en outre un agent de formation de film protecteur, sachant que l'agent de formation de film protecteur est un composé hétérocyclique ou un tensio-actif.
